(19) Europäisches Patentamt
European Patent Office
Office européen des brevets

(11) EP 0 550 202 B1

(12) EUROPEAN PATENT SPECIFICATION

(45) Date of publication and mention of the grant of the patent:
**24.04.1996 Bulletin 1996/17**

(51) Int Cl.$^6$: **C23C 16/26**, H01L 21/30

(21) Application number: **92311448.2**

(22) Date of filing: **15.12.1992**

(54) **Method of producing prestressed diamond composite films**

Methode zur Herstellung von vorgespannten diamantbeschichteten Filmen

Méthode de production de films de diamant prétendus

(84) Designated Contracting States:
**AT BE DE FR GB IE SE**

(30) Priority: **02.01.1992 US 815777**

(43) Date of publication of application:
**07.07.1993 Bulletin 1993/27**

(73) Proprietor: **GENERAL ELECTRIC COMPANY**
**Schenectady, NY 12345 (US)**

(72) Inventors:
- **Anthony, Thomas Richard**
  **Schenectady, NY 12309 (US)**
- **Fleischer, James Fulton**
  **Scotia, NY 12302 (US)**

(74) Representative: **Pratt, Richard Wilson et al**
**London Patent Operation**
**G.E. Technical Services Co. Inc.**
**Essex House**
**12/13 Essex Street**
**London WC2R 3AA (GB)**

(56) References cited:
**EP-A- 0 279 898** **EP-A- 0 411 298**
**EP-A- 0 467 043**

- **PATENT ABSTRACTS OF JAPAN, vol. 13, no. 293 (E-782), 20 March 1989 & JP-A-10 73 720 ( FUJITSU LTD )**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 550 202 B1

## Description

### FIELD OF THE INVENTION

The present invention generally relates to a method for producing diamond films by chemical vapor deposition and more particularly relates to a method used for producing composite prestressed diamond films having structural reinforcements therein.

### BACKGROUND OF THE INVENTION

Diamond is an allotrope of carbon exhibiting a crystallographic network comprising exclusively of covalently bonded, aliphatic $sp^3$ hybridized carbon atoms arranged tetrahedrally with a uniform distance of 1.545 Å (angstroms) between atoms. Diamond is extremely hard having a high Mohs hardness of 10. It exhibits four times the thermal conductivity of copper and it is electrically insulating. As a result it is an ideal heat sink or a circuit substrate for semiconductor devices.

Diamond can be grown as an equilibrium phase at high pressures or it can be grown under metastable conditions at low pressures. The present invention is directed to growing diamonds at low pressures from hydrocarbon gases in the presence of atomic hydrogen. Many methods have been disclosed for growing diamonds metastably and generally these methods differ from each other by the way in which atomic hydrogen, a key reactant, is generated and transported within the system.

One class of methods developed in recent years for producing diamonds comprises chemical vapor deposition (hereinafter sometimes "CVD") methods. For a general summary of various diamond deposition methods including CVD methods, reference is made to Chemical & Engineering News, 67(20), 24-39 (May 15, 1989). In the CVD methods, a mixture of hydrogen and a gaseous carbon compound such as methane is activated and contacted with a substrate to produce diamond film on the substrate. The hydrogen gas is dissociated into atomic hydrogen and then reacted with the carbon compound to form condensable carbon radicals including elemental carbon. The carbon radicals are then deposited on a substrate to form diamond. Some of the CVD diamond coating methods, hereinafter referred to as "filament" methods, employ one or more resistance heating units including heated wires or filaments, typically at temperatures of about 2000°C, to provide the high thermal activation temperatures necessary to bring about these conversions.

Various problems have been encountered in producing large diamond slabs, cylinders or complex three dimensional articles by CVD diamond deposition. For example, it is difficult to produce large, crack-free diamond slabs by means of conventional CVD diamond processes, where a diamond layer is deposited on one side of a substrate. One of the problems associated with the aforementioned process is that the cooling of the diamond layer and the underlying substrate from typical CVD diamond deposition temperatures to room temperature, produces contraction in the diamond layer and the substrate. Since diamond has one of the lowest coefficients of thermal expansion, the diamond layer contracts far less than the underlying substrate, thereby inducing compressive stresses on the diamond layer and tensile stresses on the substrate. As a result, the substrate is subjected to unbalanced bend moments, which may bend the substrate, if the substrate is thin enough. Since diamond is a brittle material it tends to crack when subjected to such bending stresses. If the substrate is too thick to bend, the interface between the surfaces of the diamond layer and the substrate is exposed to high stresses that may result in catastrophic release between the two surfaces, thereby producing exfoliation or fracture along the interface. The net result is that diamond layer may be broken up and cracked during its release from the substrate.

Thus, there is a need for an improved method of producing large thick diamond slabs that are structurally strong and free from cracks and distortion.

### SUMMARY OF THE INVENTION

The present invention is directed to a method of producing by chemical vapor deposition a prestressed composite diamond article having a reinforcing member therein, the method comprising the steps of symmetrically chemical vapor depositing diamond on both sides of the reinforcing member maintained at a desired chemical vapor deposition temperature, wherein the reinforcing member has a thermal coefficient of expansion equal to or greater than that of diamond, and cooling and thereby contracting the reinforcing member having a chemically vapor deposited diamond layer thereon such that a higher thermal contraction of the reinforcing member than that of the diamond layer induces balanced compressive stresses in the diamond layer to produce the prestressed diamond article.

## BRIEF DESCRIPTION OF THE DRAWINGS

Figure 1 is a cross-sectional view of the preferred embodiment of the invention illustrating locations of the heated filaments in a CVD chamber with respect to a substantially planar array of the rods that form a reinforcing member of a large diamond slab.

Figure 2 is a cross-sectional view of another embodiment of the invention illustrating locations of the heated filaments in a CVD chamber with respect to a substantially cylindrical array of the rods that form the reinforcing member of a large diamond cylinder.

Figure 3 is a cross-sectional view of another reinforcing member of the invention.

Figure 4 is a cross-sectional view of still another reinforcing member of the invention.

## DETAILED DESCRIPTION OF THE INVENTION

The present invention is directed to a method of producing prestressed diamond articles having a reinforcement therein. A theory has been developed to explain how balanced compressive stresses are developed on, for example, a planar array of reinforcing wires that form a diamond/array composite. Diamond is symmetrically chemical vapor deposited on both sides of the array. The thickness of the diamond/array composite is controlled by the rate of diamond deposition and the total time of deposition. Following the diamond deposition, the diamond/array composite is cooled from the chemical vapor deposition temperature to room temperature. Due to a mismatch between the coefficients of thermal expansion (hereinafter CTE) between the reinforcing wire material and diamond, stresses develop in the diamond/array composite. Since the composite is in mechanical equilibrium, the internal stresses must balance and net out to zero:

$$\sigma_d V_d + \sigma_w V_w = 0 \quad (1)$$

where $\sigma_d$ is the compressive stress present in the diamond phase, $V_d$ is the volume fraction of the diamond phase of the composite, $\sigma_w$ is the tensile stress present in the reinforcing wires of the array phase and $V_w$ is the volume fraction of the reinforcing wires of the array phase of the diamond/array composite.

According to Hooke's Law, stress within the elastic limits is proportional to strain. Thus the stresses present in each phase of the diamond/array composite may be determined by:

$$\sigma_d = E_d[\alpha_d \Delta T - e_c] \quad (2)$$

$$\sigma_w = E_w[\alpha_w \Delta T - e_c] \quad (3)$$

where $\alpha_d$ and $\alpha_w$ are the thermal coefficients of expansion of diamond and the reinforcing wires, respectively; $E_d$ and $E_w$ are the moduli of elasticity of diamond and the reinforcing wires, respectively; $\Delta T$ is the difference between the CVD deposition temperature and room temperature, and $e_c$ is the strain produced in the diamond/array composite by the stresses present in each phase of the diamond/array composite.

By combining Equations 1, 2 and 3 the stress present in each phase of the diamond/array composite may be calculated by:

$$\sigma_d = - V_w E_d E_w \Delta\alpha \Delta T / E_c' \quad (4)$$

$$\sigma_w = + V_d E_d E_w \Delta\alpha \Delta T / E_c \quad (5)$$

where $\Delta\alpha$ is the difference between the thermal coefficients of expansion between the reinforcing wires ($\alpha_w$) and diamond ($\alpha_d$), respectively. $E_c$ is the modulus of elasticity of the diamond/array composite determined by the law of mixtures, i.e., $E_c = V_w E_w + V_d E_d$. Since diamond is a brittle material, it is less strong in tension than in compression. Consequently, the diamond/array composite has a higher tensile strength than that of a pure diamond slab by an amount of stress provided by Equation 4.

In addition to making the diamond slab stronger, the unbalanced stresses and resulting bending moments that are typically generated when a diamond layer is deposited on one side of a substrate are avoided by centrally positioning the array within the diamond/array composite. Generally these bending moments cause a conventional diamond-on-substrate combination to bend, thereby resulting in either cracking or catastrophic exfoliation of the diamond layer from the substrate. By contrast, due to a symmetrical embedment of the array within the prestressed diamond layer, the stresses in the diamond and the array phase remain balanced, thereby increasing the structural strength of the resulting composite.

It can be shown further that the presence of an array of reinforcing material within a diamond/array composite has insignificant effect on its thermal conductivity. In the worst case scenario, where the thermal conductivity of the embedded reinforcing wires is zero, the thermal conductivity of the diamond/array composite in parallel and in pependicular directions with respect to the orientation of the reinforcing wires in the composite is provided by:

$$K_{(parallel)} = K_d V_d \quad (6)$$

$$K_{(perpendicular)} = K_d\,[(1 - V_w)/(1 + V_w)] \quad (7)$$

where $K_d$ is the thermal conductivity of pure diamond and $V_w$ is the volume fraction of the reinforcing wire. It can be shown empirically that loss of thermal conductivity of a diamond/array composite is less than 33% for a diamond/array composite having a reinforcing material at about 20% of the total volume fraction.

Turning to Figure 1 there is shown a diagrammatic view of the preferred embodiment of a prestressed composite diamond article, such as a CVD diamond slab generally represented by a numeral 1, having a reinforcing member therein. Figure 1 shows, in a plan view, a substantially planar reinforcing member 4 formed by an array of elongated members, such as rods 5 located within a conventional CVD chamber, not shown. Rods 5 are preferably arranged in a two-dimensional plane for producing CVD diamond slab 1 and are sufficiently close to one another to allow formation of a CVD diamond layer 2 across the gaps between individual rods 5.

Planar reinforcing member 4 is made of materials that are thermally and structurally stable at typical CVD diamond deposition temperatures. Additionally materials used for planar reinforcing member 4 must have coefficients of thermal expansion equal to or greater than that of diamond. Some of the materials suitable for use in the present invention are titanium, niobium, tungsten, tantalum, zirconium, hafnium, chromium, molybdenum, iron, nickel, palladium, silver, platinum, silicon nitride, silicon aluminum oxynitride, baron nitride, alumina, tungsten carbide, sapphire, carbon fiber (also known as graphite fiber) or silicon carbide. Planar reinforcing member 4 of mixed composition may also be utilized as is necessary, desirable, or convenient. Molybdenum is preferred. Reinforcing rods 5 are preferably cylindrical in shape. However, it is contemplated that any other suitable, solid or hollow shape, such as a hexagonal, rectangular, triangular tubes or rods may be also used. In order to improve interfacial adhesion between CVD diamond layer 2 and rods 5, the surface of rods 5 may be serrated, etched, grooved or otherwise roughened to improve the interfacial adhesion. Rods 5 as thin as about 1 micrometer or as thick as about 2000 micrometers or more may be employed, depending upon processing conditions, especially the rate of diamond deposition. However, the volume fraction of planar reinforcing member 4 is preferably held to less than about 20%.

The method used for carrying out the present invention will be described with reference to the accompanying drawings. In Figure 1 there is shown a diagrammatic view of the preferred embodiment of the apparatus, used for synthesizing prestressed CVD composite diamond slab 1 having reinforcements therein. Figure 1 shows a planar reinforcing member 4 formed by an array of elongated members, such as rods 5 located within the conventional CVD chamber, not shown. Reinforcing member positioning means, not shown, are used to position and secure planar reinforcing member 4 within the CVD chamber. The positioning means include means such as end caps to which rods 5 are secured. The positioning means may be further provided with means for heating planar reinforcing member 4 to typical CVD diamond deposition temperatures. Such means may be provided by direct resistive heating of reinforcing member 4 by the passage of an electrical current through rods 5 or by indirect heating of rods 5 through dielectric heating means. However, it is understood that those skilled in the art would employ other conventional heating means suitable for maintaining planar reinforcing member 4 at typical CVD diamond deposition temperatures.

In operation, any conventional CVD device capable depositing equal amounts of CVD diamond on either side of planar reinforcing member 4 may be used. Generally, a mixture of a carbon compound and hydrogen, in gaseous state is fed into the CVD chamber as an initial step. The details of the growth mechanism of the diamond in the gas phase are not clear. However, it is reported that excited species such as atomic hydrogen, methyl radical and atomic carbon, play important roles in the growth mechanism of diamonds. These excited species are produced by several CVD methods, for example, hot-filament CVD, microwave plasma CVD, electron-assisted CVD, RF plasma CVD and DC arc plasma CVD. The hot-filament CVD method is preferred.

Planar reinforcing member 4 is preferably equidistantly positioned between at least two banks of a plurality of heated filaments 6 such that equal amounts of CVD diamond are deposited on each side of planar reinforcing member 4. As a result, planar reinforcing member 4 is substantially centered within CVD composite diamond slab 1. Since planar reinforcing member 4 has two sides, two banks of filaments 6 are generally provided. However, to one skilled in the art, it would be apparent to provide more than two banks, if required, to deposit equal amounts of CVD diamond on either side of planar reinforcing member 4. Filaments 6 are made of thermally stable, non-reactive materials, such as tungsten, molybdenum, tantalum, or alloys thereof. It should be apparent to one skilled in the art to vary size, shape and number of filaments 6 necessary to optimally deposit CVD diamond layer 2 of desired thickness, at a desired rate. It should be noted that the effective diamond deposition rate is almost doubled when compared to conventional deposition rates, since diamond is deposited on both sides of slab 1 simultaneously.

With respect to conventional CVD processes, suitable for the present invention, a mixture of a carbon compound and hydrogen is fed into the CVD chamber as an initial step. Typical carbon compounds include gaseous saturated hydrocarbons, such as methane, ethane, propane; gaseous unsaturated hydrocarbons, such as ethylene, acetylene, cyclohexane. Carbon compounds, such as benzene in a vaporized state may be also used. Methane, however, is preferred. The molar ratio of the carbon compound to hydrogen broadly ranges from about 1 : 10 to about 1 : 1,000, with about 1 : 100 being preferred. The gaseous mixture optionally may be diluted with an inert gas, such as argon or

helium. The gaseous mixture is passed over hot filaments 6, shown in Figure 1. Filaments 6 generally maintained at about 1200°C to 2500°C, preferably at about 2200°C, thermally decompose the gaseous mixture into condensable carbon radicals, which are then deposited on planar reinforcing member 4, shown in Figure 1, to form CVD diamond layer 2. The aforementioned hot filament technique suitable for the present invention is illustrated in the U.S. Patent No. 4,707,384. When methane is used as the carbon compound, the following reaction is believed to take place,

$$CH_4 \xrightarrow[\text{Atomic Hydrogen}]{\text{Heat +}} \text{Diamond} + 2H_2$$

Planar reinforcing member 4 is maintained at an elevated CVD diamond forming temperature, which typically ranges from about 500°C to about 1100°C and preferably in the range of about 850°C to about 950°C, where diamond growth is at its desired rate. Pressures in the CVD chamber in the range of about 1.33Pa (0.01 Torr) to about 133 KPa (1000 Torr), advantageously at about 133 Pa to about 106.4 KPa (1 to about 800 Torr), are taught in the art, with reduced pressures being preferred. Additional details about CVD processes can be reviewed by reference to Angus, et al., Low Pressure, Metastable Growth of Diamond and 'Diamondlike' Phases, Science, volume 241, August 19, 1988, pages 913-921 and Bachmann, et al., Diamond Thin Films, Chemical Engineering News, May 15, 1989, pages 24-39.

Once CVD diamond layer 2 of desired thickness is attained, composite diamond slab 1 is cooled down to room temperature. The physical structure of CVD composite diamond slab 1 formed around a substantially centrally disposed planar reinforcing member 4 tends to minimize bending stresses that develop in slab 1 during cooling and thereby contracting of slab 1. Since planar reinforcing member 4 has a higher thermal coefficient of expansion than that of diamond it contracts faster and more than diamond. However, due to the central location of planar reinforcing member 4 in slab 1, the bending moments that generally tend to distort or bend a conventional diamond slab are absent in slab 1. Additionally, planar reinforcing member 4, due to its higher thermal shrinkage than that of diamond, contracts more than CVD diamond layer 2. As a result, CVD diamond layer 2 is prestressed by the compressive stresses and planar reinforcing member 4 is stretched by the tensile stresses.

In Figure 2, another embodiment of the present invention of a prestressed composite diamond article, generally represented by numeral 3 and having a cylindrical hollow shape, is illustrated. Figure 2 shows a cylindrical reinforcing member 8 formed by an array of elongated members, such as rods 12 located within the conventional CVD chamber, not shown. Rods 12 are sufficiently close to one another to allow formation of a CVD diamond layer 10 across the gaps between individual rods 12 to produce a CVD diamond composite cylinder 2. Cylindrical reinforcing member 8 is made of same materials as those of planar reinforcing member 2, shown in Figure 1, and described earlier.

In operation, as shown in Figure 2, cylindrical reinforcing member 8 is equidistantly positioned between at least two banks of heated filaments 14, so that equal amounts of CVD diamond are deposited on either side of cylindrical reinforcing member 8. As a result, cylindrical reinforcing member 8 is centered within CVD diamond composite cylinder 2. CVD diamond layer 10 is deposited on cylindrical reinforcing member 8 in accordance with the conventional CVD process described earlier.

Figure 3 illustrates yet another type of a reinforcing member, generally represented by numeral 16, that is suitable for producing a prestressed composite diamond article in accordance with the method of the present invention. Reinforcing member 16 is a grid formed by meshing of elongated members, such as wires 18 and 20 that are sufficiently close to one another to bridge gaps between them with a CVD diamond layer during the deposition of diamond according to the method of the present invention. Reinforcing member 16 may be planar, cylindrical or any other desired shape and it may be made of the same materials as planar reinforcing member 2, shown in Figure 1 and described earlier.

Figure 4 represents another type of a reinforcing member, generally represented by numeral 22, that is suitable for producing a prestressed composite diamond article in accordance with the method of the present invention. Reinforcing member 22 is a sieved sheet having holes 26 that are sufficiently small in diameter to be bridged over with a CVD diamond layer during deposition of diamond according to the method of the present invention. Reinforcing member 22 may be planar, cylindrical or any other desired shape and it may be made of the same materials as planar reinforcing member 2, shown in Figure 1 and described earlier.

If desired, a reinforcing member may be formed of a matting of randomly distributed fibers sufficiently far apart to allow symmetrical deposition of a CVD diamond layer thereon. The fiber volume fraction of the aforementioned reinforcing member should be less that about 3.5% of the total volume fraction. Such a reinforcing member may be made of same materials as those of planar reinforcing member 2, shown in Figure 1, and described earlier.

The prestressed composite articles are suitable for use as a heat sink or a circuit substrate of a semiconductor device.

It is further contemplated that a reinforcing member of a prestressed composite diamond article may be conveniently removed by conventional methods, such as chemical etching to produce a stress free article of pure diamond. The tunnels formed within the stress free diamond article may be used for air circulation when the article is used as a

heat exchanger or a heat sink.

Example 1.

A crack-free CVD diamond/molybdenum grid composite,1000 micrometers thick, was grown in 20 days in a conventional CVD chamber having an atmosphere of 1.5% $CH_4$ and 98.5% $H_2$. The CVD reactor had two banks of filaments with each bank being equidistantly placed on each side of the molybdenum grid comprising wires of 100 micrometers diameter, arranged on a center to center distance of 450 micrometers. Each bank of filaments had two equidistantly positioned filaments maintained at 2200°C. The volume fraction of the molybdenum grid in the composite was 3.5%.

During the cooling of the diamond/molybdenum grid composite from the CVD deposition temperature of 900°C to room temperature, the differential thermal contraction between the molybdenum ($\alpha_{molybdenum}$ = 5.1 X $10^{-6}$ cm /cm/°C (5.1 X $10^{-6}$ inch /inch/°C) grid and the diamond layer ($\alpha_{diamond}$ = 1.5 x $10^{-6}$ cm/cm/°C (1.5 X $10^{-6}$ inch /inch/°C) @ 124°C and 4.8 x $10^{-6}$ cm/cm/°C (4.8 X $10^{-6}$ inch /inch /°C @ 930°C) generated stresses that were calculated by means of Equations 4 and 5. An average differential thermal contraction coefficient over the temperature drop ($\Delta\alpha$) was determined to be 1.2 X $10^{-6}$ cm/cm/°C (1.2 X $10^{-6}$ inch/inch/°C). The temperature drop ($\Delta T$) was 880°C. The diamond/molybdenum grid composite modulus of elasticity ($E_c$) was approximately equal to that of the modulus of elasticity of pure diamond ($E_d$), since the volume fraction of the molybdenum grid in the diamond/molybdenum composite was low (3.5%). The compressive stress in the diamond phase was 13.11 MPa (1.9 X $10^3$ pounds per square inch (psi))., whereas the tensile stress in the molybdenum grid phase was 358.8 MPa (5.2 X $10^4$ psi).

If one were to presume that the molybdenum wires have zero thermal conductivity, then by using Equations 6 and 7, thermal conductivity ($K_{parallel}$) of the diamond/molybdenum grid composite, parallel to the plane of the diamond/molybdenum grid composite, was found to be 96.5% of that of pure diamond, while the thermal conductivity perpendicular to the plane of the diamond/molybdenum grid composite ($K_{perpendicular}$) was found to be 93% of that of pure diamond. The actual thermal conductivities of the diamond/molybdenum grid composite would be higher than these values because molybdenum does have a good thermal conductivity.

Example 2

A crack-free CVD diamond/molybdenum grid composite,1000 micrometers thick, was grown in 20 days in a conventional CVD chamber having an atmosphere of 1.5% $CH_4$ and 98.5% $H_2$. The CVD reactor had two banks of filaments with each bank being equidistantly placed on each side of the molybdenum grid comprising wires of 100 micrometers diameter, arranged on a center to center distance of 450 micrometers. Each bank of filaments had two equidistantly positioned filaments maintained at 2200°C. The volume fraction of the molybdenum grid in the composite was 3.5%.

The molybdenum grid was then, removed from the diamond/molybdenum composite by chemical etching of the grid in a conventional etch bath of a boiling mixture comprising equal parts by volume of Hf, $HN0_3$ and HCl.

Since the molybdenum wires were removed, there is no compressive stress present in the diamond phase of the diamond/molybdenum composite.

The thermal conductivities of the diamond layer having tunnels at its midsection were found to 96.5% and 93%, respectively, of that of pure diamond in parallel and perpendicular directions to the plane of the diamond layer.

## Claims

**1.** A method of producing by chemical vapor deposition a prestressed composite diamond article having a reinforcing member therein, said method comprising the steps of:

symmetrically chemical vapor depositing diamond on both sides of said reinforcing member maintained at a desired chemical vapor deposition temperature, wherein said reinforcing member has a thermal coefficient of expansion equal to or greater than that of diamond; and

cooling and thereby contracting said reinforcing member having a chemically vapor deposited diamond layer thereon such that a higher thermal contraction of said reinforcing member than that of said diamond layer induces balanced compressive stresses in said diamond layer to produce said prestressed diamond article.

**2.** The method according to claim 1 wherein said reinforcing member is an array of elongated members having gaps sufficiently close to one another such that said gaps between said elongated members are bridged with said diamond layer during said symmetrical chemical vapor deposition of diamond.

**3.** The method according to claim 2 wherein said elongated members are rods or tubes.

4. The method according to claim 2 wherein said array of elongated members is planar or cylindrical in shape.

5. The method according to claim 1 wherein said reinforcing member is a grid formed by meshing of elongated members sufficiently close to one another for bridging gaps between said elongated members during said symmetrical chemical vapor deposition of diamond.

6. The method according to claim 5 wherein said grid of said elongated members is planar or cylindrical in shape.

7. The method according to claim 1 wherein said reinforcing member is a matting of randomly distributed fibers sufficiently far apart to allow said symmetrical chemical vapor deposition of diamond.

8. The method according to any preceding claim wherein said reinforcing member is selected from the group consisting of titanium, niobium, tungsten, tantalum, zirconium, hafnium, chromium, molybdenum, iron, nickel, palladium, silver, platinum, silicon nitride, silicon aluminum oxynitride, boron nitride, alumina, tungsten carbide, carbon fiber, sapphire, and silicon carbide.

9. The method according to claim 1 wherein said step of symmetrical chemical vapor deposition of diamond on said reinforcing member comprises:

placing said reinforcing member in a chemical vapor deposition chamber having a plurality of heated filaments equidistantly located from each side of said reinforcing member;
thermally decomposing a gaseous mixture of carbon compound and hydrogen by contacting said mixture with said heated filaments to produce condensable carbon radicals; and
depositing said condensable carbon radicals on said reinforcing member to form said diamond layer.

10. The method according to claim 1 wherein said article is a large free standing slab used as a heat sink or a circuit substrate of a semiconductor device.

11. A method of producing by chemical vapor deposition a prestressed composite diamond slab having reinforcing molybdenum rods therein, said method comprising the steps of:

placing said rods to form a planar array in a chemical vapor deposition chamber having a plurality of heated filaments equidistantly located from both sides of said array of said rods;
thermally decomposing a gaseous mixture of carbon compound and hydrogen by contacting said mixture with said heated filaments to produce condensable carbon radicals; and
symmetrically depositing said condensable carbon radicals on both sides of said array to form a diamond layer thereon; and
cooling and thereby contracting said rods such that higher thermal contraction of said rods than that of said diamond layer induces balanced compressive stresses in said diamond layer of said slab to produce said prestressed diamond slab.

12. A method of producing by chemical vapor deposition a diamond article, said method comprising the steps of:

symmetrically chemical vapor depositing diamond on both sides of a reinforcing member maintained at a desired chemical vapor deposition temperature, wherein said reinforcing member has a thermal coefficient of expansion equal to or greater than that of diamond;
cooling and thereby contracting said reinforcing member having a chemically vapor deposited diamond layer thereon such that higher thermal contraction of said reinforcing member than that of said diamond layer induces balanced compressive stresses in said diamond layer of said article to produce said diamond article; and
removing said reinforcing member from said article to form said diamond article.

13. The method according to claim 12 wherein said reinforcing member is chemically etched out of said diamond article.

**Patentansprüche**

1. Verfahren zum Herstellen eines vorgespannten Diamant-Verbundgegenstandes, der ein verstärkendes Teil enthält, durch chemisches Aufdampfen, wobei das Verfahren die Stufen umfaßt:

symmetrisches, chemisches Aufdampfen von Diamant auf beide Seiten des verstärkenden Teiles, das bei einer erwünschten Temperatur zum chemischen Aufdampfen gehalten wird, wobei das verstärkende Teil einen Koeffizienten der Wärmeausdehnung aufweist, der gleich dem von Diamant oder größer ist und
Abkühlen und dabei Zusammenziehen des verstärkenden Teiles, das eine chemisch aufgedampfte Diamantschicht aufweist, derart, daß ein stärkeres, thermisches Zusammenziehen des verstärkenden Teiles als der Diamantschicht ausgeglichene Kompressionsspannungen in der Diamantschicht erzeugt, um den vorgespannten Diamantgegenstand herzustellen.

2. Verfahren nach Anspruch 1, worin das verstärkende Teil eine Anordnung langgestreckter Teile mit genügend engen Spalten ist, derart, daß die Spalte zwischen den langgestreckten Teilen während des symmetrischen, chemischen Aufdampfens von Diamant mit der Diamantschicht überbrückt werden.

3. Verfahren nach Anspruch 2, worin die langgestreckten Teile Stäbe oder Rohre sind.

4. Verfahren nach Anspruch 2, worin die Anordnung langgestreckter Teile eine planare oder zylindrische Gestalt hat.

5. Verfahren nach Anspruch 1, worin das verstärkende Teil ein Gitter ist, gebildet durch genügend enges Inberührungbringen der langgestreckten Teile miteinander, um Spalte zwischen den langgestreckten Teilen während des symmetrischen, chemischen Aufdampfens von Diamant zu überbrücken.

6. Verfahren nach Anspruch 5, worin das Gitter aus langgestrecktzen Teilen eine planare oder zylindrische Gestalt hat.

7. Verfahren nach Anspruch 1, worin das verstärkende Teil eine Matte aus statistisch veiteilten Fasern ist, die genügend weit auseinander liegen, um das symmetrische, chemische Aufdampfen von Diamant zu gestatten.

8. Verfahren nach einem vorhergehenden Anspruch, worin das verstärkende Teil ausgewählt ist aus der Gruppe bestehend aus Titan, Niob, Wolfram, Tantal, Zirkonium, Hafnium, Chrom, Molybdän, Eisen, Nickel, Palladium, Silber, Platin, Siliciumnitrid, Siliciumaluminiumoxynitrid, Bornitrid, Aluminiumoxid, Wolframcarbid, Kohlenstoffaser, Saphir und Siliciumcarbid.

9. Verfahren nach Anspruch 1, worin die Stufe des symmetrischen, chemischen Aufdampfens von Diamant auf das verstärkende Teil umfaßt:

Anordnen des verstärkenden Teiles in einer Kammer zum chemischen Aufdampfen, die mehrere erhitzte Glühfäden in gleichem Abstand von jeder Seite des verstärkenden Teiles aufweist;
thermisches Zersetzen einer gasförmigen Mischung aus Kohlenstoffverbindung und Wasserstoff durch Inberührungbringen der Mischung mit den erhitzten Glühfäden zur Erzeugung kondensierbarer Kohlenstoffradikale und
Abscheiden der kondensierbaren Kohlenstoffradikale auf dem verstärkenden Teil zur Bildung der Diamantschicht.

10. Verfahren nach Anspruch 1, worin der Gegenstand eine große, freistehende Platte ist, die als eine Wärmesenke oder ein Schaltungssubstrat für eine Halbleitervorrichtung benutzt wird.

11. Verfahren zum Herstellen einer vorgespannten Diamant-Verbundplatte, die verstärkende Molybdänstäbe enthält, durch chemisches Aufdampfen, wobei das Verfahren die Stufen umfaßt:

Anordnen der Stäbe unter Bildung einer planaren Anordnung in einer Kammer zum chemischen Aufdampfen, bei der mehrere erhitzte Glühfäden in gleichem Abstand von beiden Seiten der Anordnung von Stäben angeordnet sind;
thermisches Zersetzen einer gasförmigen Mischung aus Kohlenstoffverbindung und Wasserstoff durch Inberührungbringen der Mischung mit den erhitzten Glühfäden zur Erzeugung kondensierbarer Kohlenstoffradikale;
symmetrisches Abscheiden der kondensierbaren Kohlenstoffradikale auf beiden Seiten der Anordnung zur Bildung einer Diamantschicht darauf und
Abkühlen und dadurch Zusammenziehen der Stäbe derart, daß das stärkere thermische Zusammenziehen der Stäbe als der Diamantschicht ausgeglichene Kompressionsspannungen in die Diamantschicht der Platte

einführt, um die vorgespannte Diamantplatte herzustellen.

**12.** Verfahren zum Herstellen eines Diamantgegenstandes durch chemisches Aufdampfen, wobei das Verfahren die Stufen umfaßt:

symmetrisches, chemisches Aufdampfen von Diamant auf beide Seiten eines verstärkenden Teiles, das bei einer erwünschten Temperatur zum chemischen Aufdampfen gehalten wird, wobei das verstärkende Teil einen Koeffizienten der Wärmeausdehnung aufweist, der gleich oder größer als der von Diamant ist;
Abkühlen und dadurch Zusammenziehen des verstärkenden Teiles, das eine chemisch aufgedampfte Diamantschicht aufweist, derart, daß das stärkere thermische Zusammenziehen des verstärkenden Teiles als der Diamantschicht ausgeglichene Kompressionsspannungen in die Diamantschicht des Gegenstandes einführt, um den genannten Diamantgegenstand herzustellen und
Entfernen des verstärkenden Teiles aus dem Gegenstand zur Bildung des Diamantgegenstandes.

**13.** Verfahren nach Anspruch 12, worin das verstärkende Teil chemisch aus dem Diamantgegenstand herausgeätzt wird.

**Revendications**

**1.** Procédé de fabrication par dépôt chimique à partir d'une phase gazeuse d'un objet en diamant, composite et précontraint, contenant un élément de renfort, ledit procédé comprenant les étapes consistant à :

- faire déposer de façon symétrique, à partir d'une phase gazeuse, du diamant sur les deux faces dudit élément de renfort maintenu à une température souhaitée de dépôt chimique à partir d'une phase gazeuse, sachant que ledit élément de renfort a un coefficient de dilatation thermique égal ou supérieur à celui du diamant, et
- faire refroidir, et par là contracter, ledit élément de renfort sur lequel se trouve une couche de diamant déposée à partir d'une phase gazeuse de telle sorte que la contraction thermique dudit élément de renfort plus importante que celle de ladite couche de diamant induise des contraintes de compression équilibrées dans ladite couche de diamant afin de produire ledit objet en diamant précontraint.

**2.** Procédé selon la revendication 1, dans lequel ledit élément de renfort est un réseau d'éléments allongés avec des interstices entre eux, suffisamment proches les uns des autres pour que lesdits interstices entre lesdits éléments allongés soient comblés par ladite couche de diamant pendant ledit dépôt chimique symétrique du diamant à partir d'une phase gazeuse.

**3.** Procédé selon la revendication 2, dans lequel lesdits éléments allongés sont des barres ou des tubes.

**4.** Procédé selon la revendication 2, dans lequel ledit réseau d'éléments allongés est de forme plane ou cylindrique.

**5.** Procédé selon la revendication 1, dans lequel ledit élément de renfort est une grille formée par un treillis d'éléments allongés suffisamment proches les uns des autres pour que les interstices entre lesdits éléments allongés soient comblés pendant ledit dépôt chimique symétrique du diamant à partir d'une phase gazeuse.

**6.** Procédé selon la revendication 5, dans lequel ladite grille d'éléments allongés est de forme plane ou cylindrique.

**7.** Procédé selon la revendication 1, dans lequel ledit élément de renfort est un mat de fibres réparties au hasard, suffisamment espacées pour permettre ledit dépôt chimique symétrique du diamant à partir d'une phase gazeuse.

**8.** Procédé selon l'une quelconque des précédentes revendications, dans lequel ledit élément de renfort est choisi dans le groupe formé par le titane, le niobium, le tungstène, le tantale, le zirconium, l'hafnium, le chrome, le molybdène, le fer, le nickel, le palladium, l'argent, le platine, le nitrure de silicium, l'oxynitrure d'aluminium et de silicium, le nitrure de bore, l'alumine, le carbure de tungstène, les fibres de carbone, le saphir et le carbure de silicium.

**9.** Procédé selon la revendication 1, dans lequel ladite étape de dépôt chimique symétrique du diamant à partir d'une phase gazeuse sur ledit élément de renfort comprend :

- la mise en place dudit élément de renfort dans une chambre de dépôt chimique à partir d'une phase gazeuse

qui comporte une pluralité de filaments chauffés situés à égale distance de chaque côté dudit élément de renfort,
- la décomposition thermique d'un mélange gazeux fait d'un composé carboné et d'hydrogène par mise en contact dudit mélange avec lesdits filaments chauffés afin de produire des radicaux de carbone condensables, et
- le dépôt desdits radicaux de carbone condensables sur ledit élément de renfort pour former ladite couche de diamant.

**10.** Procédé selon la revendication 1, dans lequel ledit objet est grande plaque autoporteuse utilisée comme puits de chaleur ou support de circuit dans un dispositif à semi-conducteur.

**11.** Procédé de fabrication par dépôt chimique à partir d'une phase gazeuse d'une plaque en diamant, composite et précontrainte contenant des barres de renfort en molybdène, ledit procédé comprenant les étapes consistant à :

- mettre en place lesdites barres pour former un réseau plan dans une chambre de dépôt chimique à partir d'une phase gazeuse qui comporte une pluralité de filaments chauffés situés à égale distance de chaque côté dudit réseau de barres,
- faire décomposer thermiquement un mélange gazeux fait d'un composé carboné et d'hydrogène par mise en contact dudit mélange avec lesdits filaments chauffés afin de produire des radicaux de carbone condensables,
- faire déposer de façon symétrique lesdits radicaux de carbone condensables sur les deux faces dudit réseau pour former sur celui-ci une couche de diamant, et
- faire refroidir, et par là contracter, lesdites barres de telle sorte que la contraction thermique desdites barres plus importante que celle de ladite couche de diamant induise des contraintes de compression équilibrées dans ladite couche de diamant de ladite plaque afin de produire ladite plaque en diamant précontrainte.

**12.** Procédé de fabrication par dépôt chimique à partir d'une phase gazeuse d'un objet en diamant, ledit procédé comprenant les étapes consistant à:

- faire déposer de façon symétrique, à partir d'une phase gazeuse, du diamant sur les deux faces d'un élément de renfort maintenu à une température souhaitée de dépôt chimique à partir d'une phase gazeuse, sachant que ledit élément de renfort a un coefficient de dilatation thermique égal ou supérieur à celui du diamant,
- faire refroidir, et par là contracter, ledit élément de renfort sur lequel se trouve une couche de diamant déposée à partir d'une phase gazeuse de telle sorte que la contraction thermique dudit élément de renfort plus importante que celle de ladite couche de diamant induise des contraintes de compression équilibrées dans ladite couche de diamant afin de produire ledit objet en diamant, et
- retirer ledit élément de renfort dudit objet pour terminer ledit objet en diamant.

**13.** Procédé selon la revendication 12, dans lequel ledit élément de renfort est retiré dudit objet en diamant par attaque chimique.

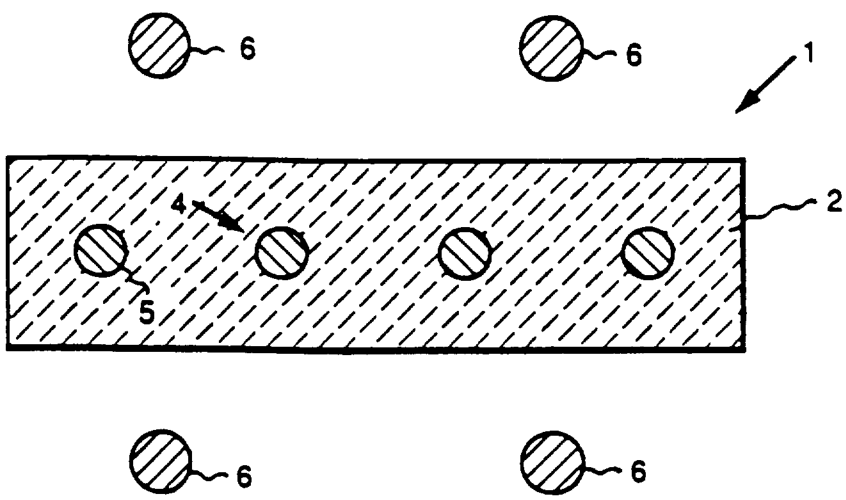


FIG. 1

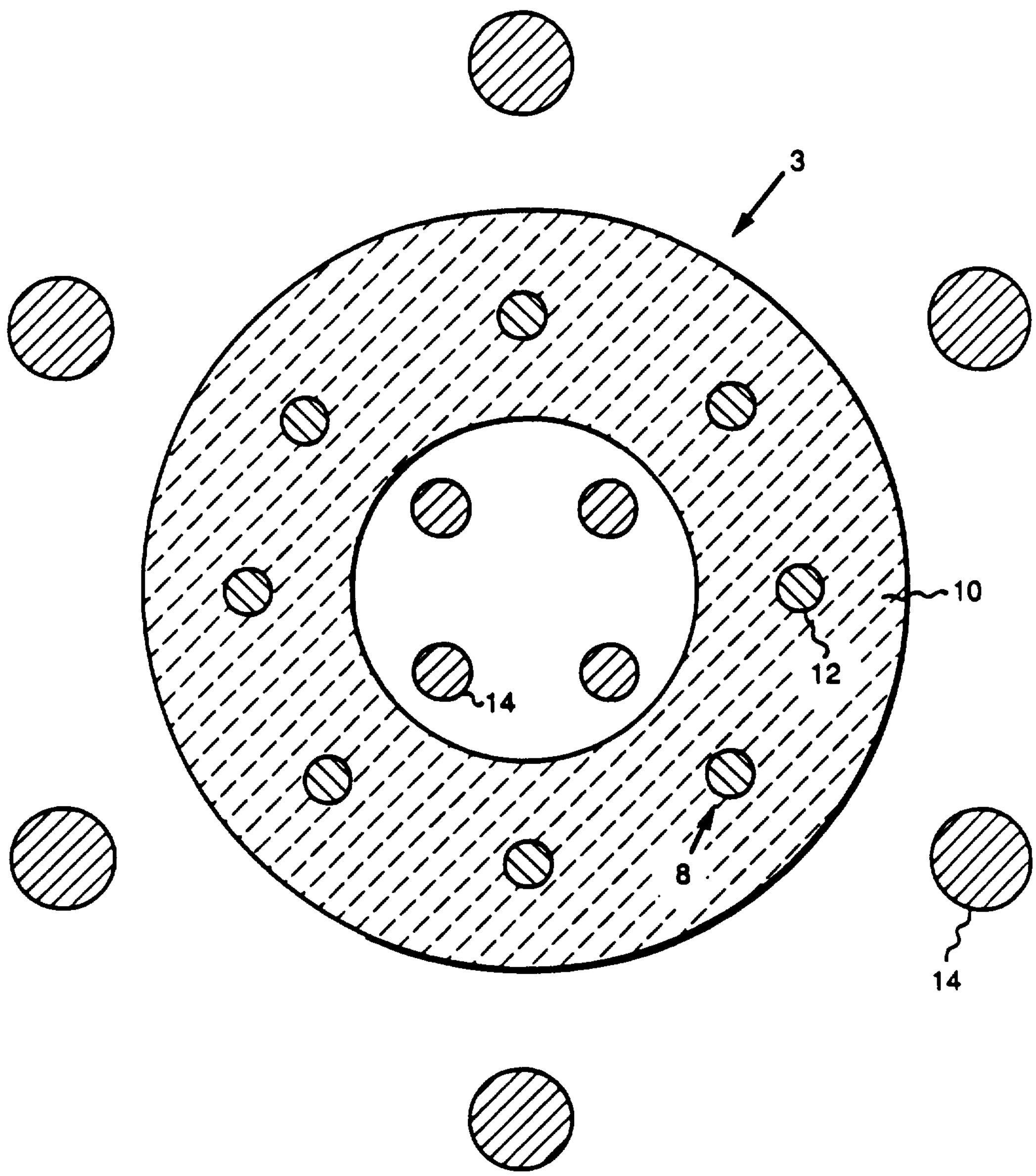


FIG. 2

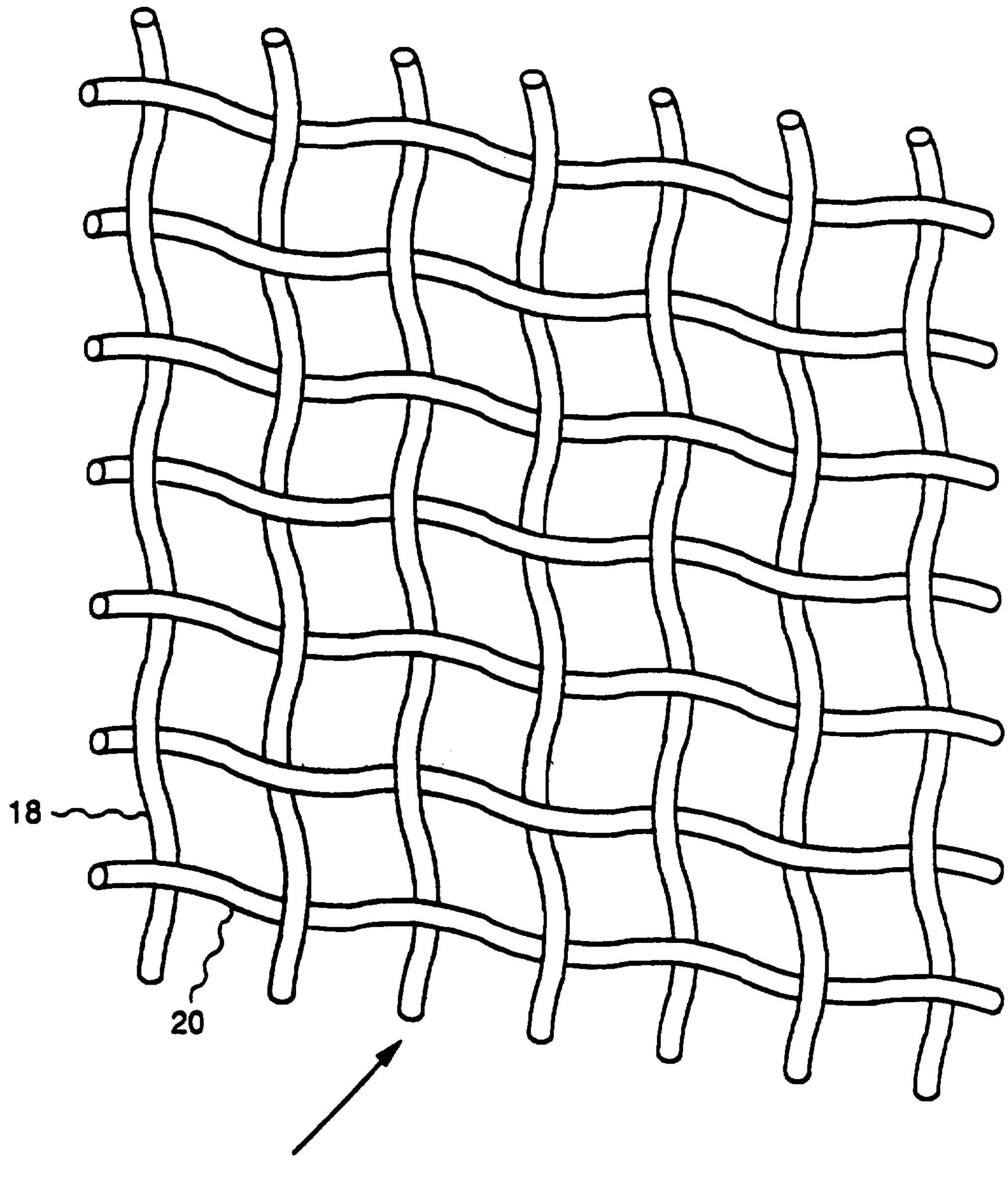


FIG. 3

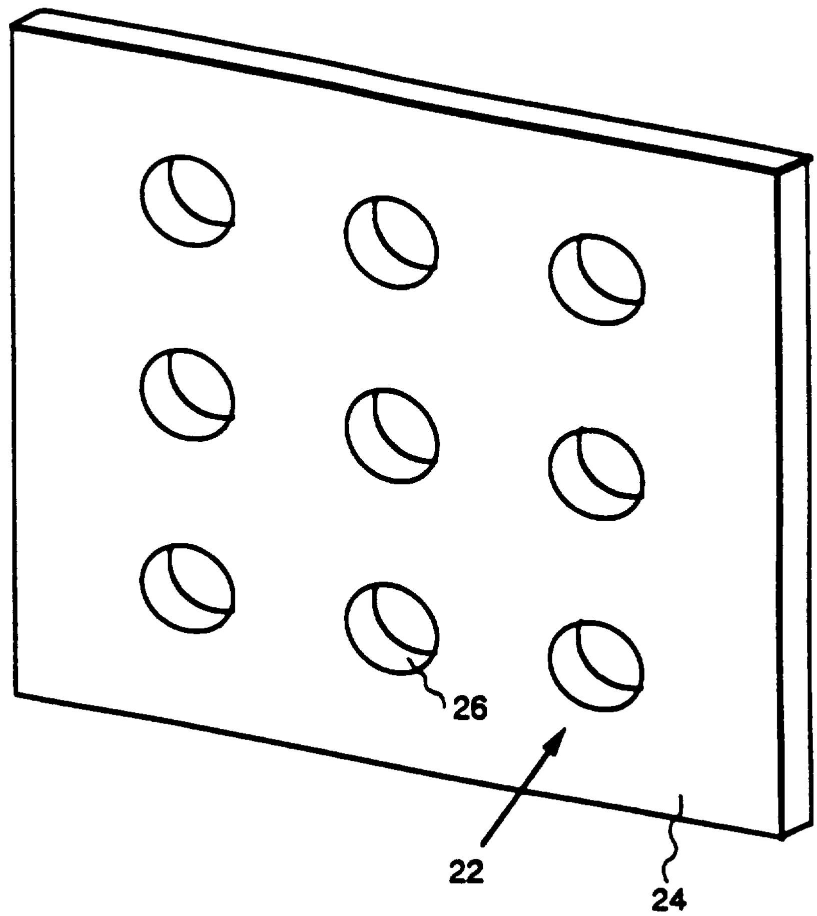


FIG. 4